# EUROPEAN PATENT APPLICATION

(11) **EP 2 270 981 A2**
(43) Date of publication of application: **05.01.2011**
(21) Application number: 10166373.0
(22) Date of filing: 17.06.2010
(51) Int. Cl.: H03H 17/02

(54) **Digital signal processing apparatus and digital signal processing method**

(30) Priority: 19.06.2009 JP 2009146801
(71) Applicant: FUJITSU LIMITED, Kawasaki-shi, Kanagawa 211-8588 (JP)
(72) Inventor: Kanayama, Yasutaka, Kawasaki-shi Kanagawa 211-8588 (JP); Koizumi, Nobukazu, Kawasaki-shi Kanagawa 211-8588 (JP)
(74) Representative: Fenlon, Christine Lesley

(57) **Abstract**

A digital signal processing apparatus includes a frame generator configured to generate a plurality of frames from a row of sample data of a time-domain, a part of each frame overlapping with adjoining frames, a Fourier transform unit configured to transform at least one of the generated frames into a frequency domain by Fourier transformation, an addition unit configured to add predetermined frequency characteristic to the transformed frame, and an inverse Fourier transform unit configured to transform the added frame into the time-domain by inverse Fourier transformation and to delete the overlap of the frame of the time-domain transformed.

## Description

### FIELD

The embodiments discussed herein are relates to digital signal processing apparatuses and digital signal processing methods that perform digital signal processing.

### BACKGROUND

With the advance of digital technologies in recent years, digital signal processing has been used in various fields. For example, complicated waveform equalizer processing that is difficult to implement by an analog circuit is implemented by digital signal processing. The filter performing digital signal processing is called a digital filter. Representative digital filters may include a finite impulse response filter (FIR filter) and an infinite impulse response filter (IIR filter).

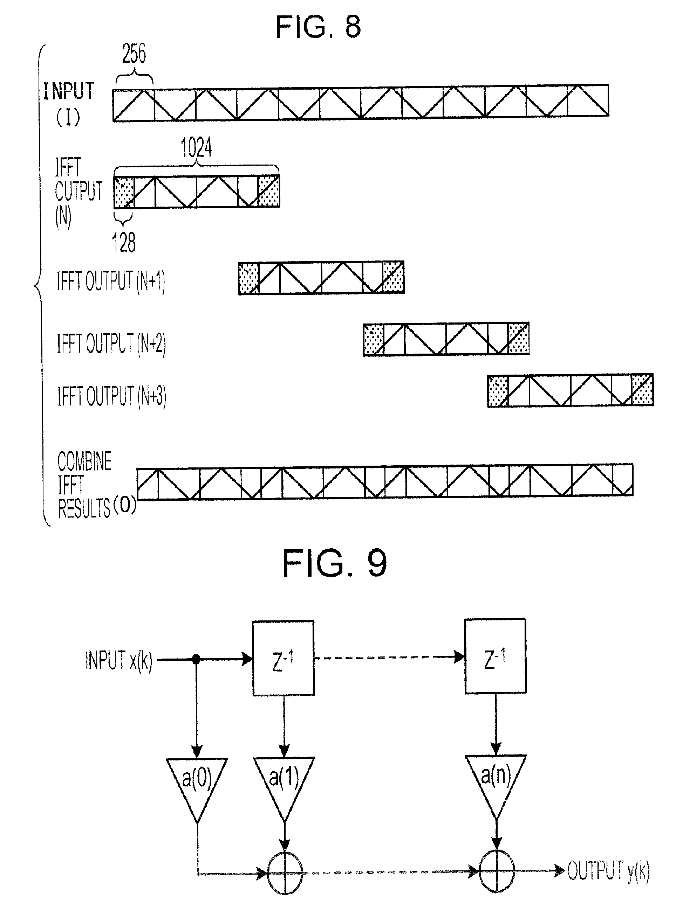

For example, an FIR filter as illustrated in FIG. 9 has been known. The FIR filter has no feedback loops but is a finite impulse response filter with impulse responses expressed by a finite number of pulses. The illustrated transfer function in the FIR filter is an example where an input is x(k) and a tap weight (or tap coefficient) is a. The FIR filter illustrated in FIG. 9 is a direct-form FIR filter. A delay of one sample is expressed by a transfer function z⁻¹.

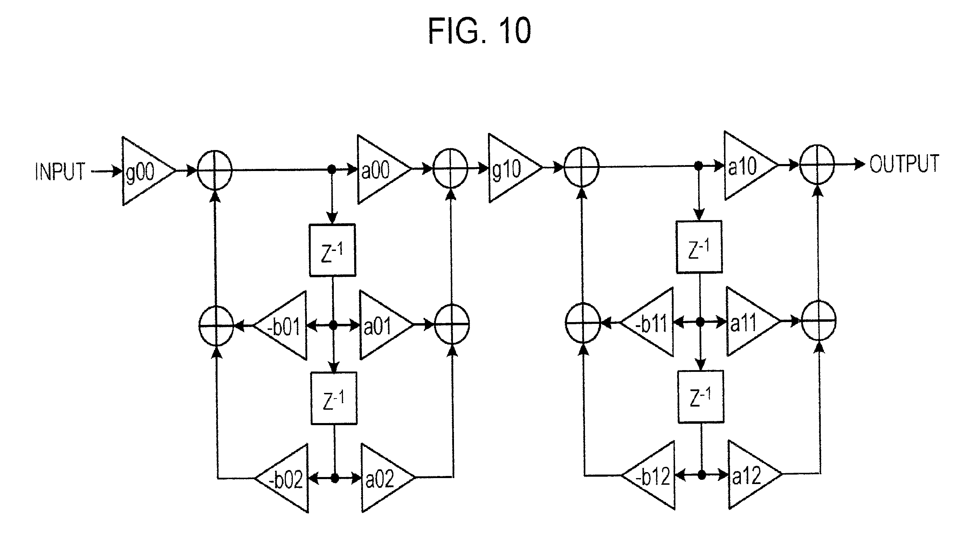

An IIR filter as illustrated in FIG. 10 has been known. The IIR filter adds inputs and outputs the value resulting from the multiplication of the inputs with coefficients a00, a01, a02, -b01, and -b02 ... by multipliers. A delay element then delays an intermediate variable for each sample or for each line.

The FIR filter and IIR filter have a frequency characteristic (such as an amplitude characteristic and a phase characteristic) depending on the transfer function. In general, in order to obtain a steep or complicated frequency characteristic, a high-order digital filter may be applied. A normal FIR filter has 100 or higher orders. The increase in order means an increase in the number of multiplications. For example, an FIR filter of 100 orders may require 101 multiplications for outputting one sample. On the other hand, an IIR filter of lower orders than that of an FIR may easily obtain a steep characteristic. However, since an IIR filter has a feedback loop, designing such an IIR filter may sometimes be difficult.

A digital signal processing circuit will be examined by using an inexpensive CMOS process in a case where a digital filter is used in a very high speed sampling system running at several tens GHz. In this case, the digital signal processing circuit is applied to perform serial/parallel conversion on an ADC sampling signal and perform digital signal processing on the parallel receive signals such that the operating frequency can be approximately several hundreds MHz.

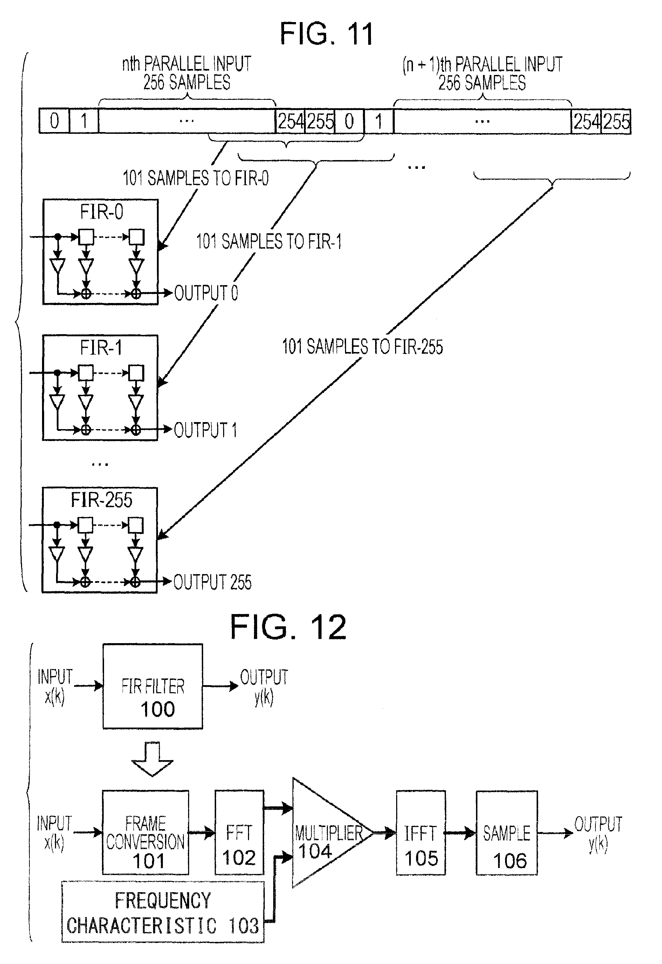

For example, processing data input at 51.2 GHz in an LSI operating at 200 MHz is processing the input for 256 samples in one clock. As illustrated in FIG. 11, 256 digital filter circuits may be operated in parallel. This means an FIR filter of 100 orders having 101 × 256 = 25856 multipliers to be provided in the circuit. The number of multipliers has a large influence on the size of the circuit. The size of the circuit in this case may be significantly huge. Installing the circuit to an LSI may also be difficult.

An IIR filter of fewer orders than an FIR filter has a feedback path for calculation results. Thus, feedback processing within one clock is difficult to perform on the parallel receive signal sequences. Therefore, an IIR filter is not applicable in this case.

In order to avoid the increase in size of the circuit, a digital filter 101 using FFT (101) and IFFT (102) has been used. As illustrated in FIG. 12, a sample sequence in the time domain (input x(k)) is converted into frames with a predetermined window size (101) and is converted to data in the frequency domain through FFT (102). In order to add a frequency characteristic (103) (such as amplitude characteristic and a phase characteristic) in the frequency domain, the frequency components are multiplied with the complex coefficients representing amplitude and a phase (104), for example. The frequency components after the multiplication undergo IFFT (105) back to sample sequences in the time domain (106). Then, the sample sequence is output(y(k)).

Depending on the frequency characteristics, when a characteristic equivalent to an FIR filter of 100 orders is implemented by a window size of 1024 samples, the numbers of multiplications in FFT and IFFT normally fit in N × log 2N (where N is a window size). In this case, the number of multiplications for FFT is 1024 × 10, is also 1024 × 10 for IFFT, and is 1024 for the frequency-characteristic addition. 1024 × 21 which is sum total value, that is, 21 multiplications is implemented for one sample. In order to add a more complicated characteristic, an FIR filter of twice orders doubles the number of multiplications. However, the twice window sizes for FFT and IFFT may only increase the number of multiplications for one sample by one each for FFT and IFFT. This can largely reduce the size of the circuit more than an FIR-based circuit.

FFT and IFFT are originally to be performed on data buffered for a window size. Thus, FFT and IFFT are suitable for the parallel inputs of receive signals. 256 parallel inputs may be implemented by 21 × 256 = 5376 multipliers which may be reduced to half or below by improvements such as butterfly computations with cardinal number 4, cardinal number 8 or the like or pipeline operations. In this way, many advantages are provided by the filtering in the frequency domain through FFT and IFFT on parallel inputs of receive signals. These technologies may be disclosed in Japanese Laid-open Patent Publication Nos. 5-183442, 5-297898, 8-160994, 11-38997, 2000-207000, and 2004-507922.

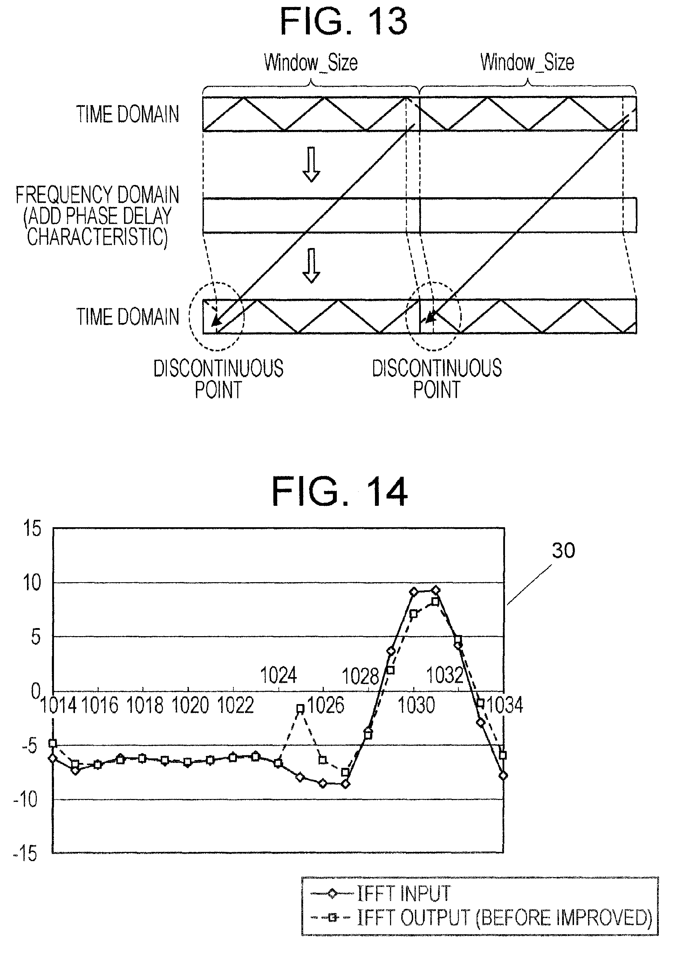

The digital filter technologies using FFT and IFFT can be implemented when samples in the time domain and the frequency domain are regarded as having cyclic values on a period equal to a frame length. Thus, ends of frames at the FFT input are regarded as being continuous. When a phase delay characteristic is added in the frequency domain, discontinuous points may occur at ends of the frames at the IFFT output, as illustrated in FIG. 13. Therefore, a proper result of the filtering is difficult to acquire.

FIG. 14 illustrates the occurrence of a discontinuous point at the boundary at the IFFT output when a frequency characteristic (with a phase delay) is actually added to frames each having a length of 1024 samples. In the example in FIG. 14, the 1025th sample is discontinuous.

### SUMMARY

Accordingly, it is desirable to provide an apparatus that may remove discontinuous points occurring upon addition of a frequency characteristic.

According to an embodiment of an aspect of the invention, a digital signal processing apparatus includes a frame generator configured to generate a plurality of frames from a row of sample data of a time-domain, a part of each frame overlapping with adjoining frames, a Fourier transform unit configured to transform at least one of the generated frames into a frequency domain by Fourier transformation, an addition unit configured to add predetermined frequency characteristic to the transformed frame, and an inverse Fourier transform unit configured to transform the added frame into the time-domain by inverse Fourier transformation and to delete the overlap of the frame of the time-domain transformed.

### BRIEF DESCRIPTION OF THE DRAWINGS

FIG. 1 is a block diagram illustrating a digital signal processing apparatus according to a first embodiment.

FIG. 2 is a block diagram illustrating a digital signal processing apparatus 10 according to a second embodiment.

FIG. 3 illustrates input frame generation processing and output frame extraction processing.

FIG. 4 illustrates examples of output results of IFFT.

FIG. 5 is a block diagram illustrating a digital signal processing apparatus according to a third embodiment.

FIG. 6 illustrates input frame generation processing and output frame extraction processing.

FIG. 7 illustrates input frame generation processing and output frame extraction processing.

FIG. 8 illustrates processing of deleting eighths of an output frame.

FIG. 9 illustrates a configuration example of an FIR filter.

FIG. 10 illustrates a configuration example of an IIR filter.

FIG. 11 illustrates a configuration example of an FIR filter for 256 parallel inputs.

FIG. 12 illustrates a configuration example of an FIR filter using FFT and IFFT.

FIG. 13 illustrates the occurrence of discontinuous points due to a phase delay.

FIG. 14 illustrates the occurrence of a discontinuous point after IFFT.

### DESCRIPTION OF THE EMBODIMENTS

With reference to the attached drawings, embodiments of a digital signal processing apparatus and digital signal processing method will be described in detail below.

[First Embodiment]

Hereinafter, the configuration and processing of a digital signal processing apparatus according to a first embodiment will be described, which is followed by the description on the advantages of the first embodiment.

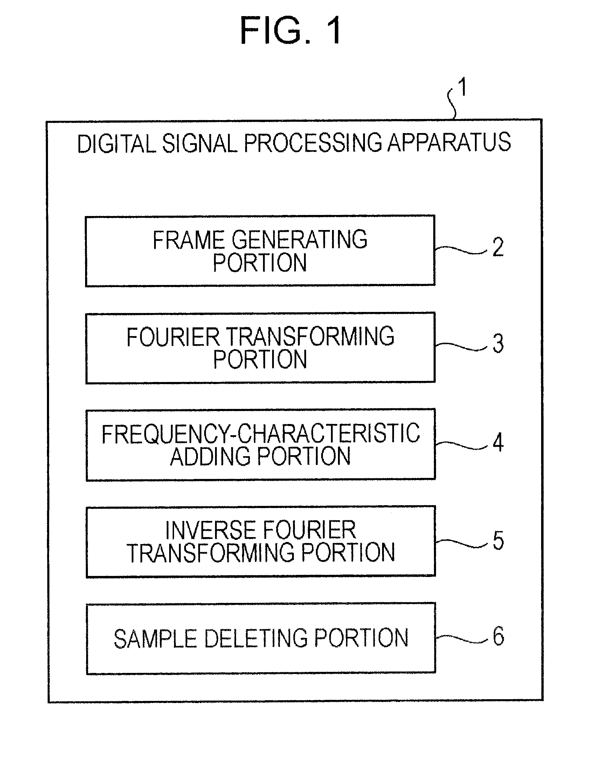

First of all, with reference to FIG. 1, the configuration and processing of a digital signal processing apparatus according to the first embodiment will be described. FIG. 1 is a block diagram illustrating a digital signal processing apparatus according to the first embodiment.

A digital signal processing apparatus 1 of the first embodiment includes a frame generating portion 2, a Fourier transforming portion 3, a frequency-characteristic adding portion 4, an inverse Fourier transforming portion 5, and a sample deleting portion 6.

The frame generating portion 2 generates a plurality of frames overlapping predetermined sections from a sample sequence in the time domain. The Fourier transforming portion 3 performs Fourier transform on the frames generated by the frame generating portion 2 to convert them to the frequency domain.

The frequency-characteristic adding portion 4 adds a frequency characteristic to the frames converted to the frequency domain by the Fourier transforming portion 3. The inverse Fourier transforming portion 5 performs inverse Fourier transform on the frames added a frequency characteristic by the frequency-characteristic adding portion 4 to convert them to sample sequences in the time domain.

The sample deleting portion 6 deletes the overlapped parts in the sample sequences in the time domain converted by the inverse Fourier transforming portion 5.

In this way, the digital signal processing apparatus 1 generates frames overlapping a longer section than a group delay from a sample sequence in the time domain. After performing the Fourier transform processing, frequency-characteristic addition processing, and inverse Fourier transform processing, the digital signal processing apparatus 1 deletes both ends of the sample sequences. Thus, discontinuous points occurring upon addition of a frequency characteristic can be removed.

Therefore, the discontinuous points at the ends of frames at the IFFT output can be removed, and a proper result of the filtering can be acquired.

[Second Embodiment]

Hereinafter, a configuration and processing flow of a digital signal processing apparatus according to a second embodiment be described, which will be followed by the advantages of the second embodiment. The digital signal processing apparatus will be applied to an FIR filter in the following example.

[Digital Signal Processing Apparatus]

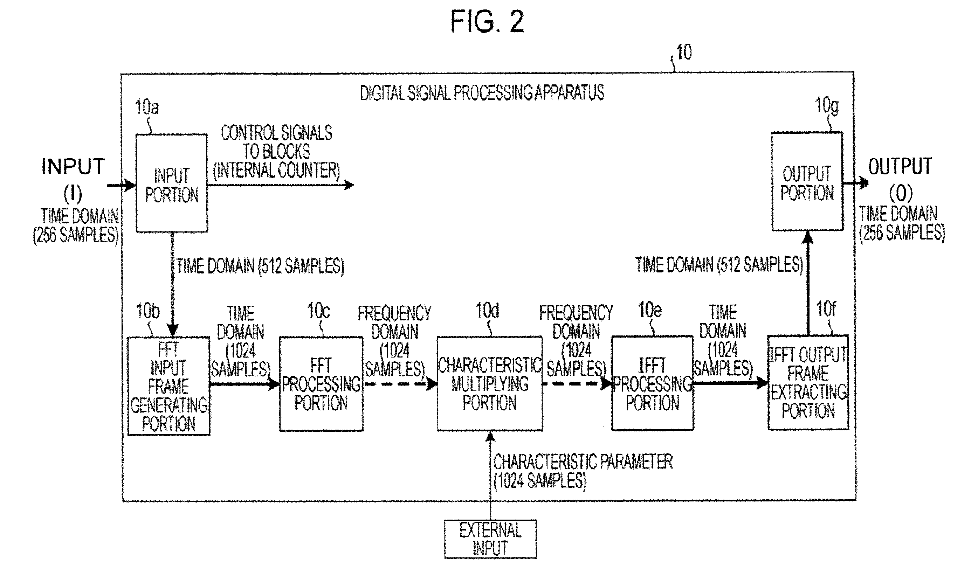

With reference to FIG. 2, a digital signal processing apparatus 10 will be described. FIG. 2 is a block diagram illustrating a digital signal processing apparatus 10 according to the second embodiment. As illustrated in FIG. 2, the digital signal processing apparatus 10 includes an input portion 10a, an FFT input frame generating portion 10b, an FFT processing portion lOc, a characteristic multiplying portion 10d, an IFFT processing portion 10e, an IFFT output frame extracting portion 10f, and an output portion 10g. The processing to be performed by these portions will be described below. In the following example, a sample sequence for a length of 256 is input in one clock, and frames with a window size of 1024 are generated.

The input portion 10a buffers a sample sequence of input data (I) for a length of 256 inputs in one clock. The input portion 10a then reads two buffered sample sequences each for a length of 256 and generates a frame of 512 samples once for every two clocks. The input portion 10a outputs the frame to the subsequent FFT input frame generating portion 10b. The input portion 10a further inputs the value of an internal counter that is a control signal to the other portions.

The FFT input frame generating portion 10b generates frames overlapping a longer section than a group delay from a sample sequence in the time domain. More specifically, the FFT input frame generating portion 10b combines one previous frame of 512 samples and the present frame of 512 samples to generate a frame of 1024 samples. The FFT input frame generating portion 10b inputs the generated frame to the FFT processing portion 10c. The length of the overlapping section may be defined in accordance with the frequency characteristic.

The FFT processing portion 10c performs Fourier transform on the generated frame to convert it to data in the frequency domain. More specifically, the FFT processing portion 10c performs Fourier transform on the frame input from the FFT input frame generating portion 10b to convert it to data in the frequency domain. The FFT processing portion 10c inputs the data to the characteristic multiplying portion 10d.

The characteristic multiplying portion 10d adds a frequency characteristic to the frame converted to the frequency domain by the FFT processing portion 10c. For example, the characteristic multiplying portion 10d externally receives a characteristic parameter, 1024 samples, for each frequency component and multiplies it with the corresponding frequencies. The characteristic multiplying portion 10d then inputs the data added the frequency characteristic to the IFFT processing portion 10e.

The IFFT processing portion 10e performs inverse Fourier transform on the frame added the frequency characteristic to convert it to the sample sequence in the time domain. More specifically, the IFFT processing portion 10e performs inverse Fourier transform on the data input from the characteristic multiplying portion 10d to convert them to sample sequences in the time domain and inputs the sample sequence to the IFFT output frame extracting portion 10f.

The IFFT output frame extracting portion 10f deletes both ends of the sample sequence in the time domain converted by the IFFT processing portion 10e. More specifically, the IFFT output frame extracting portion 10f deletes each end of the sample sequence in the time domain input by the IFFT processing portion 10e by a quarter (equal to 256 samples) and inputs the result to the output portion 10g.

The output portion 10g outputs the input sample sequence (as output data (0)) for a length of 256 for every one clock. More specifically, the output portion 10g slices 512 samples output from the IFFT output frame extracting portion 10f for every two clocks by 256 samples for every one clock and outputs them in parallel.

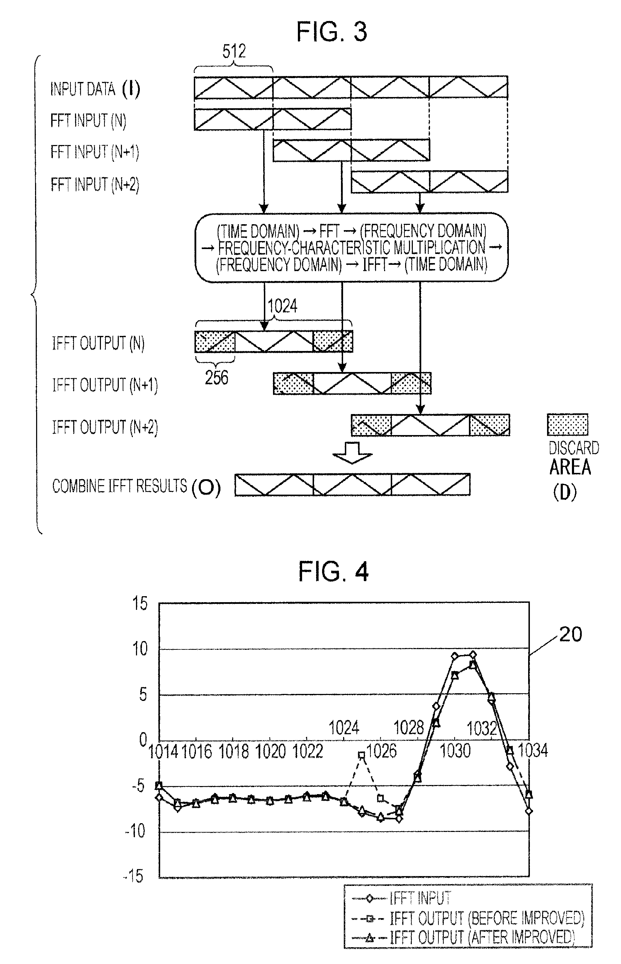

With reference to FIG. 3, input frame generation processing and output frame extraction processing will be described. FIG. 3 illustrates input frame generation processing and output frame extraction processing. As illustrated in FIG. 3, the digital signal processing apparatus 10 combines an one previous input frame of 512 samples of input data (I) and the previous frame of 512 samples of input data (I) to sequentially generate an FFT input (N) frame, FFT input (N + 1) frame, FFT input (N + 2) frame and so on of 1024 samples.

The digital signal processing apparatus 10 then performs Fourier transform (FFT) on the data in the time domain to convert them to data in the frequency domain. The digital signal processing apparatus 10 multiplies the data in the frequency domain with a frequency characteristic. The digital signal processing apparatus 10 performs inverse Fourier transform (IFFT) on the data in the frequency domain multiplied with a frequency characteristic to convert them to data in the time domain.

Since the first and last parts of the IFFT output frame contain discontinuous points, the digital signal processing apparatus 10 discards the first and last 256 samples, that is, a quarter of the window size of the IFFT output frame. If the discontinuous points are contained within the parts to be discarded (D), the output data (0) combining the remaining data of 512 samples do not have discontinuous points.

As described above, the digital signal processing apparatus 10 generates frames of a longer section than a group delay from a sample sequence in the time domain. The digital signal processing apparatus 10 performs Fourier transform on the generated frames to convert them to the frequency domain. The digital signal processing apparatus 10 adds the frames converted to the frequency domain a frequency characteristic. The digital signal processing apparatus 10 then performs inverse Fourier transform on the frames added a frequency characteristic to convert them to sample sequences in the time domain. The digital signal processing apparatus 10 deletes both ends of the converted sample sequence in the time domain. Thus, discontinuous points at ends of the frame at the IFFT output can be removed, and proper filtering result can be acquired.

With reference to FIG. 4, an output result of the IFFT will be described.

FIG. 4 illustrates an example of an output result of the IFFT. FIG. 4 illustrates an IFFT input, an IFFT output (before improved) from a digital signal processing apparatus in the past, and an IFFT output (after improved) from the digital signal processing apparatus 10 according to the second embodiment.

As illustrated in FIG. 4, the IFFT output from a digital signal processing in the past has a discontinuous point at the 1025th sample. On the other hand, the IFFT output from the digital signal processing apparatus 10 according to the second embodiment hides the discontinuous point at an end of the frame at the IFFT output. Thus, a proper filtering result can be acquired.

According to the second embodiment, the digital signal processing apparatus 10 deletes quarters of both ends of the converted sample sequence in the time domain. The simple circuit configuration allows removal of discontinuous points at the ends of the frame at the IFFT output and can provide a proper filtering result.

According to the second embodiment, the processing of performing Fourier transform on frames to convert them to the frequency domain is performed serially in a time-division manner. The processing of adding the frame converted to the frequency domain a frequency characteristic is performed serially in a time-division manner. The processing of performing inverse Fourier transform on the frames added a frequency characteristic to convert them to sample sequences in the time domain is performed serially in a time-division manner. Therefore, the throughputs of the FFT and IFFT operations may be raised, and a set of the FFT processing portion, characteristic multiplying portion and IFFT processing portion may be operated serially (or in a pipeline manner) to remove the discontinuous points at the ends of the frames at the IFFT output for a proper filtering result.

According to the second embodiment, the length of the overlapping section may be arbitrarily defined. Thus, the length of the overlapping section may be defined in accordance with the frequency characteristic to be added.

[third embodiment]

Having described according to the second embodiment that the FFT processing is performed on frames overlapping by half serially or in a pipeline manner, the embodiment is not limited thereto. Frames overlapping each other by half may be processed in two processing lines in parallel.

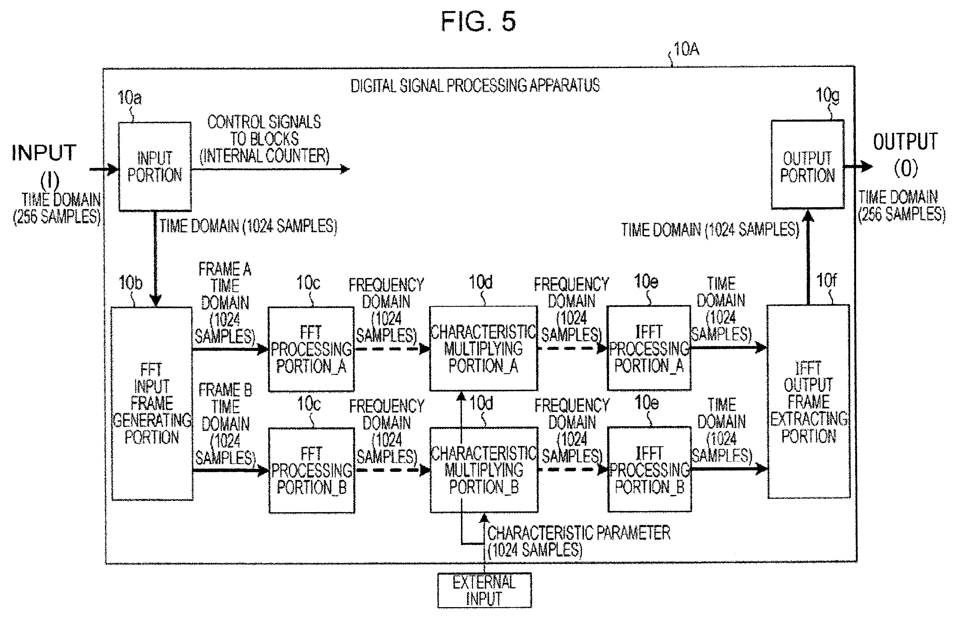

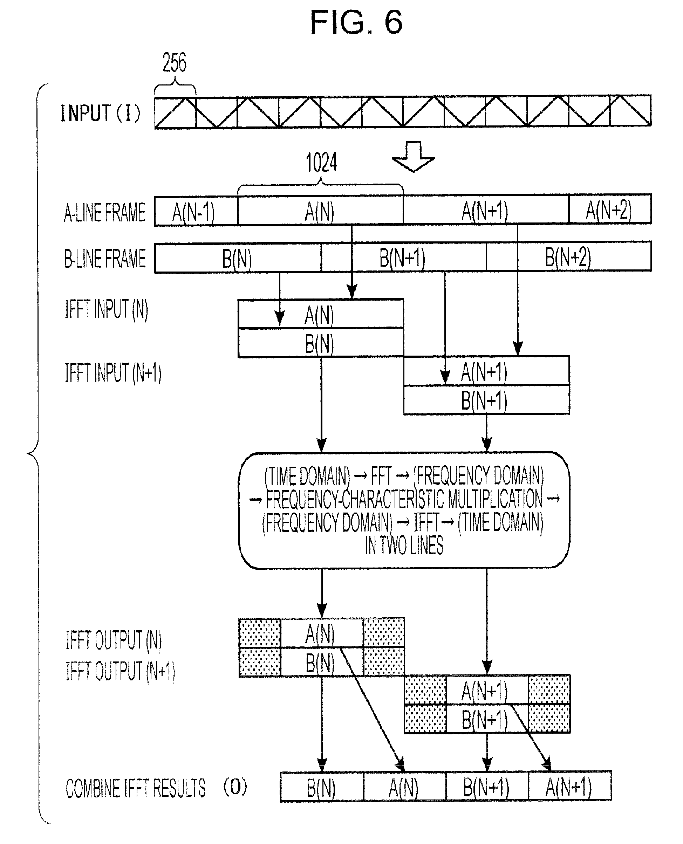

With reference to Figs. 5 and 6, a digital signal processing apparatus 10A according to a third embodiment will be described where frames overlapping each other by half may be processed in two processing lines in parallel. FIG. 5 is a block diagram illustrating a digital signal processing apparatus according to the third embodiment. FIG. 6 illustrates input frame generation processing and output frame extraction processing.

The digital signal processing apparatus 10A according to the third embodiment is different from the second embodiment in that the digital signal processing apparatus 10A includes two lines of the FFT processing portion 10c, characteristic multiplying portion 10d and IFFT processing portion 10e. In other words, as illustrated in FIG. 5, the digital signal processing apparatus 10A includes an FFT processing portion_A and an FFT processing portion_B, a characteristic multiplying portion_A and a characteristic multiplying portion_B, an IFFT processing portion_A and an IFFT processing portion_B.

The input portion 10a generates frames of 1024 samples once for every four clocks from input data (I). The FFT input frame generating portion 10b generates two of a "frame A" being the present frame and a "frame B" being a frame of 1024 samples combining the second half 512 samples of one previous frame and the first half 512 samples of the present frame. The FFT input frame generating portion 10b then inputs the frame A and frame B to the FFT processing portion_A and the FFT processing portion_B, respectively.

The FFT processing portion_A and FFT processing portion_B perform two lines of FFT processing on the frame A and frame B in parallel to convert them to data in the frequency domain and inputs the data to the characteristic multiplying portion_A and characteristic multiplying portion_B. The characteristic multiplying portion_A and characteristic multiplying portion_B perform two lines of frequency characteristic addition processing in parallel to add the data a frequency characteristic and inputs the resulting data to the IFFT processing portion_A and IFFT processing portion_B.

The IFFT processing portion_A and IFFT processing portion_B perform two lines of IFFT processing on the data in parallel to convert the data to sample sequences in the time domain and input the sample sequences to the IFFT output frame extracting portion 10f. The IFFT output frame extracting portion 10f discards the first and last 256 samples of the sample sequences in the time domain input from the IFFT processing portion 10e, combines the frame B and frame A in the order and outputs the result (as output data (O)).

The digital signal processing apparatus 10A has a throughput of once for every four clocks instead of once for every two clocks according to the second embodiment. Thus, the digital signal processing apparatus 10A can be implemented in hardware with a computing unit shared in a pipeline manner and without large differences in number of multipliers and size of the circuit from the second embodiment.

With reference to FIG. 6, input frame generation processing and output frame extraction processing by the digital signal processing apparatus 10A will be described. FIG. 6 illustrates input frame generation processing and output frame extraction processing. As illustrated in FIG. 6, the digital signal processing apparatus 10A sequentially generates two of a frame A ("A-line frame" in the example in FIG. 6) being the present frame and a frame B ("B-line frame" in the example in FIG. 6) being a frame of 1024 samples combining the second half 512 samples of one previous frame and the first half 512 samples of the present frame of input data (I).

The digital signal processing apparatus 10A then performs in parallel two lines the processing of performing Fourier transform on the data in the time domain to convert them into data in the frequency domain, multiplying the data in the frequency domain with a frequency characteristic, and performing inverse Fourier transform on the data in the frequency domain multiplied with a frequency characteristic to convert them to data in the time domain.

After that, the digital signal processing apparatus 10A discards the first and last 256 samples of the frames in the time domain after the inverse Fourier transform, combines the frame B and the frame A in the order and outputs the result. For example, as illustrated in FIG. 6, the digital signal processing apparatus 10A performs inverse Fourier transform on the frame A at the IFFT output (N) and the frame B at the IFFT output (N) and then performs inverse Fourier transform on the frame A at the IFFT output (N + 1) and the frame B at the IFFT output (N + 1).

In this case, the digital signal processing apparatus 10A sequentially outputs the frame B at the IFFT output (N), the frame A at the IFFT output (N), the frame B, at the IFFT output (N + 1), and the frame A at the IFFT output (N + 1), as output data (O).

In this way, according to the third embodiment, the digital signal processing apparatus 10A performs Fourier transform on a plurality of frames in parallel to convert them into the frequency domain, adds in parallel a frequency characteristic to the plurality of frames converted to the frequency domain, and performs inverse Fourier transform in parallel on the plurality of frames added the frequency characteristic to convert them into a sample sequence in the time domain. Thus, the digital signal processing apparatus 10A operates a plurality of sets of the FFT processing portion, characteristic multiplying portion and IFFT processing portion in parallel and removes discontinuous points at the ends of the frames at the IFFT output. As a result a proper filtering result can be acquired.

[Other Embodiments]

Having described embodiments up to this point, the embodiments may be implemented in various different forms in addition to the aforementioned embodiments. Some, but not all, other embodiments will be described below.

[1] The number of parallel processing lines

According to the third embodiment, two lines of the FFT processing, frequency characteristic addition processing and IFFT processing are performed in parallel. Two or more lines of the FFT processing, frequency characteristic addition processing and IFFT processing may be performed in parallel.

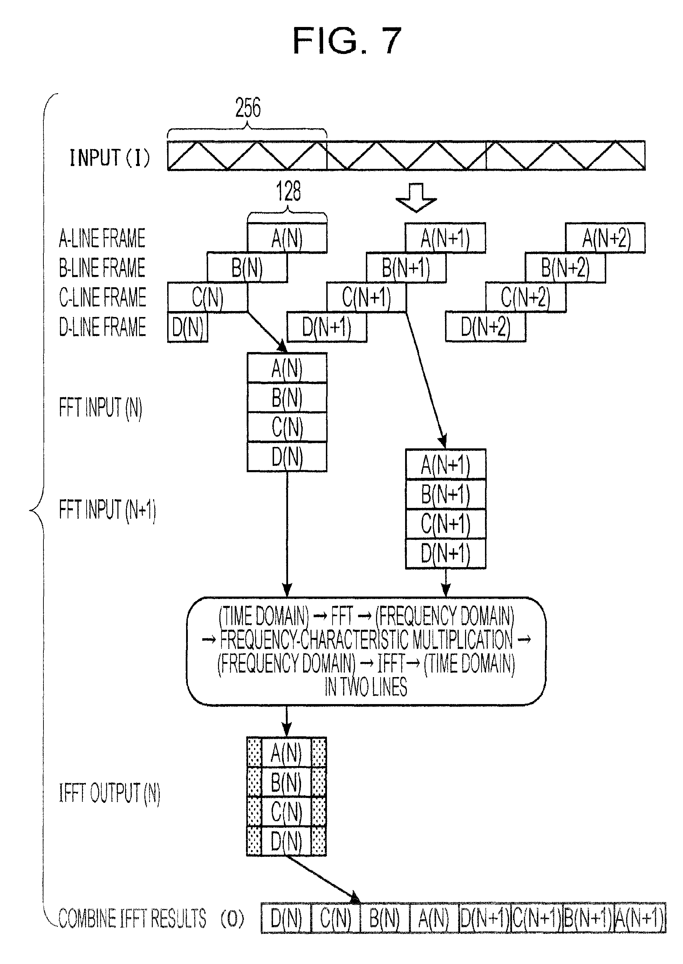

For example, as illustrated in FIG. 7, a digital signal processing apparatus may sequentially generate an A-line frame being the present frame, a B-line frame being a frame of 128 samples combining the second half 64 samples of one previous frame from the present frame and the first half 64 samples of the present frame, a C-line frame being one previous frame from the present frame, and a D-line frame being a frame of 128 samples combining the second half 64 samples of the two previous frame from the present frame and the first half 64 samples of one previous frame from the present frame.

The digital signal processing apparatus may then perform in parallel four lines of processing of performing Fourier transform on the data in the time domain to convert them to the data in the frequency domain, multiplying the data in the frequency domain with a frequency characteristic, and performing inverse Fourier transform on data in the frequency domain multiplied with a frequency characteristic to convert them into data in the time domain. After that, the digital signal processing apparatus discards the first and last 32 samples of the sample sequences in the time domain after the inverse Fourier transform and combines and outputs the D-, C-, Band A-line frames in the order.

In this way, preparing and operating a plurality of processing lines in parallel is suitable when the window size for the FFT and IFFT is equal to or lower than the number of parallel inputs. For processing 256 parallel inputs serially or in a pipeline manner with a window size of 256, one throughput is 128 samples, that is, 0.5 clocks, which disable the serial processing after the FFT processing. However, processing the 256 parallel inputs in parallel allows the completion of the entire processing. Thus, even with a frame size of 128, the number of parallel processing lines may be increased to four for the entire processing, as described above.

[2] Sample Deletion Range

Having described according to the first to third embodiments that quarters of each end of a sample sequence is deleted. The part to be deleted from a sample sequence may be defined in accordance with the frequency characteristic to be added. For example, as illustrated in FIG. 8, the first and last eighths may be deleted.

In the digital signal processing apparatus, the input portion buffers 256 parallel inputs and generates a frame of 768 samples once for every three clocks. The FFT input frame generating portion combines the present 768 samples and the second half 256 samples of one previous frame to generate a frame of 1024 samples. The IFFT output frame extracting portion discards 128 samples that is an eighth of the window size at each end and transmits the remaining 768 samples to the output portion.

In this way, compared with the deletion of quarters at both ends, the deletion of eighths at both ends allows one throughput for every 3 clocks. Therefore, with a shared computing unit, for example, the size of the circuit and power consumption can further be reduced. Even in a system having a frequency characteristic requiring the deletion of quarters at both ends at a maximum, a sufficient characteristic may be acquired with the deletion of eighths at both ends under some conditions where the system is placed. In this case, an operating mode with the deletion of eighths at both ends may be set to lower the operating ratio of the computing unit and thus reduce the power consumption. In accordance with the frequency characteristic and/or phase delay to be added, an optimum window size for FFT and IFFT and an optimum amount of discard may be determined.

The range to be deleted in a sample sequence may be defined arbitrarily. Thus, the range to be deleted in a sample sequence may be defined in accordance with the frequency characteristic to be added by the frequency-characteristic adding portion.

[3] System Configuration and Others

The frame generating portion 2 and the Fourier transforming portion 3 may be integrated. All or an arbitrary part of the processing functions implemented by the devices may be implemented by a CPU and a program to be analyzed and executed by the CPU or by a hard wired logic.

[4] Programs

The digital signal processing method according to the aforementioned embodiments may be implemented by executing causing a computer such as a personal computer and a workstation to execute a prepared program. The program may be distributed over a network such as the Internet. The program may be recorded in a computer-readable recording medium such as a hard disk, a flexible disk (FD), a CD-ROM, an MO and a DVD and may be read from the recording medium.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiment(s) of the present invention has(have) been described in detail, it should be understood that the various changes, substitutions, and alterations could be made hereto without departing from the spirit and scope of the invention.

## Claims

1. A digital signal processing apparatus comprising:
a frame generator configured to generate a plurality of frames from a row of sample data of a time-domain, a part of each frame overlapping with adjoining frames;
a Fourier transform unit configured to transform at least one of the generated frames into a frequency domain by Fourier transformation;
an addition unit configured to add predetermined frequency characteristic to the transformed frame; and
an inverse Fourier transform unit configured to transform the added frame into the time-domain by inverse Fourier transformation and to delete the overlap of the frame of the time-domain transformed.

2. The digital signal processing apparatus according to claim 1,
wherein the Fourier transform unit transforms the generated plurality of frames into a frequency domain by Fourier transformation; and
further comprising a combine unit configured to combine the frames output from the inverse Fourier transform unit.

3. The digital signal processing apparatus according to claim 1 or 2, wherein the length of the part of each frame overlapped is 1/4 of lengths of each of the corresponding frames.

4. The digital signal processing apparatus according to claim 1, 2 or 3, wherein
the addition unit adds the predetermined frequency characteristic and predetermined phase characteristic to the transformed frame.

5. The digital signal processing apparatus according to any preceding claim, wherein
the length of the part of each frame overlapped is corresponding to the predetermined frequency characteristic.

6. The digital signal processing apparatus according to claim 2, or any one of claims 3 and 5 when read as appended to claim 2, wherein
the Fourier transform unit transforms a plurality of the generated frames into a frequency domain by Fourier transformation by parallel processing,
the addition unit adds predetermined frequency characteristic to the transformed frames by parallel processing, and
the inverse Fourier transform unit transforms the added frames into the time-domain by parallel processing.

7. A digital signal processing method, said method comprising:
generating a plurality of frames from a row of sample data of a time-domain, a part of each frame overlapping with adjoining frames;
transforming, by Fourier transformation, at least one of the generated frames into a frequency domain;
adding predetermined frequency characteristic to the transformed frame;
transforming the added frame into the time-domain by inverse Fourier transformation; and
deleting the overlap of the frame of the time-domain transformed.

8. The digital signal processing method according to claim 7,
wherein the transforming transforms the generated plurality of frames into a frequency domain by Fourier transformation; and
further combining the frames after the deleting.

9. The digital signal processing method according to claim 7 or 8, wherein the length of the part of each frame overlapped is 1/4 of lengths of each of the corresponding frames.

10. The digital signal processing method according to claim 7, 8 or 9, wherein
the adding adds the predetermined frequency characteristic and predetermined phase characteristic to the transformed frame.

11. The digital signal processing method according to claim 7, 8, 9 or 10, wherein
the length of the part of each frame overlapped is corresponding to the predetermined frequency characteristic.

12. A computer-readable recording medium storing a computer program being designed to make a computer perform the steps of:
generating a plurality of frames from a row of sample data of a time-domain, a part of each frame overlapping with adjoining frames;
transforming, by Fourier transformation, at least one of the generated frames into a frequency domain;
adding predetermined frequency characteristic to the transformed frame;
transforming the added frame into the time-domain by inverse Fourier transformation; and
deleting the overlap of the frame of the time-domain transformed.

13. The recording medium according to claim 12,
wherein the transforming transforms the generated plurality of frames into a frequency domain by Fourier transformation; and
further combining the frames after the deleting.

14. The recording medium according to claim 12 or 13, wherein
the length of the part of each frame overlapped is 1/4 of lengths of each of the corresponding frames.

15. The recording medium according to claim 12, 13 or 14, wherein
the adding adds the predetermined frequency characteristic and predetermined phase characteristic to the transformed frame.

16. The recording medium according to claim 12, 13, 14 or 15, wherein
the length of the part of each frame overlapped is corresponding to the predetermined frequency characteristic.
